# EUROPEAN PATENT SPECIFICATION

(11) **EP 3 457 198 B1**
(45) Date of publication and mention of the grant of the patent: **22.11.2023**
(21) Application number: 17801966.7
(22) Date of filing: 20.03.2017
(51) Int. Cl.: G02F 1/1333, G06F 1/16, H04M 1/03, H04M 1/02

(54) **COMPONENT COMPRISING HOUSING AND SCREEN**
KOMPONENTE MIT GEHÄUSE UND BILDSCHIRM
COMPOSANT COMPRENANT UN BOÎTIER ET UN ÉCRAN

(30) Priority: 27.05.2016 CN 201610367873
(43) Date of publication of application: 20.03.2019
(73) Proprietor: Huawei Technologies Co., Ltd., Longgang District Shenzhen, Guangdong 518129 (CN)
(72) Inventor: BAI, Jianwei, Shenzhen Guangdong 518129 (CN); CHEN, Guiyun, Shenzhen Guangdong 518129 (CN); TAN, Dongsheng, Shenzhen Guangdong 518129 (CN); LUO, Guang, Shenzhen Guangdong 518129 (CN)
(74) Representative: Epping - Hermann - Fischer
(86) International application number: PCT/CN2017/077356
(87) International publication number: WO 2017/202118

(56) References cited:
- CN-A- 102 533 206
- CN-A- 104 834 399
- CN-A- 104 850 183
- CN-U- 204 334 654
- CN-U- 204 389 833
- CN-U- 205 065 448
- CN-U- 205 121 112
- CN-U- 205 179 150
- CN-U- 205 229 632
- DE-A1-102015 009 897
- US-A1- 2010 103 138
- US-A1- 2015 382 484

## Description

This application claims priority to Chinese Patent Application No. 201610367873.5, filed with the Chinese Patent Office on May 27, 2016 and entitled "COMPONENT INCLUDING HOUSING AND SCREEN".

### TECHNICAL FIELD

The present invention relates to the consumer electronics field, and in particular, to a component including a housing and a screen.

### BACKGROUND

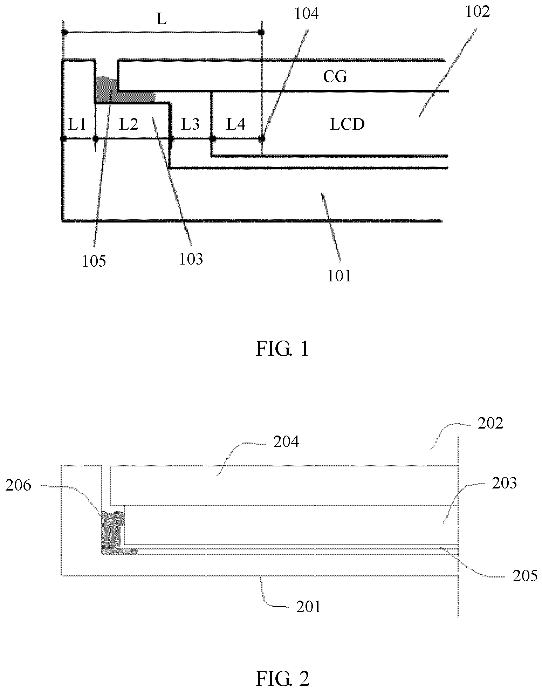

FIG 1 is a schematic diagram of a position in which glue dispensing is performed when a screen and a housing of a mobile phone are connected in the prior art. As shown in FIG 1, a housing 101 and a screen 102 are included. The screen 102 is a combined module including cover glass (CG, Cover Glass), a display module (DM, Display Module), and a touch panel (TP, Touch Panel). The touch panel shown in FIG 1 may be embedded in the display module, or may be located outside the display module, and the cover glass is disposed outside the display module to protect the display module from being damaged. The housing 101 further includes a housing step 103, and the housing step 103 is configured to place glue 105, so as to integrate the housing 101 and the screen 102 by means of connection. L1 is a width of the housing, L2 is a width of the housing step, L3 is a width of a gap between the display module and the housing, and L4 is a width 104 of a display dead zone of the display module. L=L1+L2+L3+L4, and L is referred to as a width of a frame. When L is relatively small, the mobile phone is referred to a narrow-frame mobile phone. For a narrow-frame mobile phone, a frame of a mobile phone screen is downscaled to maximize the mobile phone screen, and a size of the mobile phone is also controlled. Therefore, a user can experience a larger visible area without increasing the size of the mobile phone.

In an existing technical solution, the screen is usually fastened by adhering the CG to the housing because the display module cannot bear excessively large pressure. To connect the housing to the screen, first the glue is dispensed on the housing step, and then the screen and the housing are pressed together. The glue is flattened and spills and extends towards both sides, forming adhesion between the CG and the housing. The glue is solidified after pressure maintaining is performed for a period of time, and the screen and the housing are adhered together.

Therefore, in the prior art, L2 is set to implement a secure connection between the screen and the housing, so as to increase a width of the frame and reduce a ratio of a screen visible area in a screen surface area. In addition, because the glue is disposed on the housing step, when a position of the glue on the housing step deviates, the glue flows to the gap between the display module and the housing, possibly causing a fault on the display module, or when the glue flows to the housing, a flaw is caused in appearance.

CN 104834399 A1 relates to a touch display apparatus including a cover lens, a touch module disposed under the cover lens, a display module disposed on a surface of the touch module away from the cover lens, a casing, and a protection frame. The casing receives the cover lens and supports the touch module and the display module. The protection frame is fixed on an outside surface of the casing. The protection frame faces a sidewall of the cover lens and the touch module.

DE 10 2015 009897 A1 relates to a display screen for use in a motor vehicle, comprising: a display module covered with a coverslip, wherein the coverslip comprises a first protrusion along its circumference, the first protrusion protruding the display module; and a carrier element fixed to the display module. The first protrusion comprises an adhesive region at least in a partial area along its circumference, the adhesive region being formed for a first glue joint with the carrier element.

US 2015/382484 A1 relates to a display module comprising: a window member comprising a front surface, a rear surface facing the front surface in a thickness direction, and a connection surface coupling the front surface to the rear surface; a display panel comprising a display part spaced apart from the rear surface of the window member and to display an image toward the window member, and an edge part bent from the display part toward the window member; and a protective frame coupled to at least one of the rear surface of the window member and the connection surface to accommodate the display panel.

CN 204389833 U relates to a water-mist-proof hermetically-sealed construction with glass displays.

### SUMMARY

The invention is set out in the appended claims. Embodiments of the present invention provide a component including a housing and a screen, to reduce a width of a frame of a housing, so that a ratio of a visible area of a mobile phone screen is maximized, and a size of a mobile phone is also controlled. Therefore, a user can experience a larger visible area without increasing the size of the mobile phone.

According to an aspect, a specific embodiment of the present invention provides a component including a housing and a screen, where the screen includes cover glass, a touch panel, and a display module, and the display module, the touch panel, and the cover glass are connected in sequence from the bottom to top. The screen further includes a protective frame, and the protective frame wraps the bottom and a side face of the display module. Glue is disposed on a side face of the screen, and the housing is connected to the screen by using the glue in accordance wih the features of claim 1. The protective frame is disposed under the display module, so that the side face of the screen is directly connected to the housing, so as to reduce a width of a frame, thereby maximizing a ratio of a visible area of the mobile phone screen. Therefore, a larger visible area can be experienced without increasing a size of the mobile phone.

The glue is disposed on the side face of the screen, and the housing is connected to the screen by using the glue. A first joint face is formed between the housing and the display module provided with the protective frame, a second joint face is formed between the housing and the cover glass, and the housing is connected to the screen by using the first joint face and the second joint face. The housing is connected to the screen by using the first joint face and the second joint face, so that the display screen is waterproof and dustproof.

In a possible design, the display module includes a backlight plate. In accordance with the features of claim 1, the protective frame wraps the bottom and the side face of the display module. The protective frame may totally wrap the bottom and a side face of the backlight plate of the display module. The protective frame is used to wrap the bottom and the side face of the backlight plate of the display module, thereby reducing a material of the protective frame.

In accordance with the features of claim 1, the protective frame wraps the bottom and the side face of the display module. The protective frame may totally wrap the bottom and the side face of the display module. The protective frame wraps the display module, so that quality of the display module wrapped by the protective frame is more stable.

In a possible design, the housing is a front housing. The screen is connected to the front housing, achieving better connection stability.

In a possible design, the housing is a middle frame. The screen is connected to the middle frame, achieving better connection stability.

In a possible design, the housing is a rear housing. The screen is connected to the rear housing, achieving better connection stability.

The present invention provides the component including the housing and the screen, and the protective frame is disposed on the display module of the screen in accordance with the features of claim 1. The backlight plate, if present, of the display module is wrapped by the protective frame, so that the display module and the cover glass are directly connected to a side face of the housing. In this case, a width of a frame of a mobile phone can be reduced, and therefore a ratio of a visible area of the mobile phone screen is maximized, and a size of the mobile phone is also controlled. Therefore, a user can experience a larger visible area without increasing the size of the mobile phone.

### BRIEF DESCRIPTION OF DRAWINGS

FIG 1 is a schematic diagram of a position in which glue dispensing is performed when a screen and a housing of a mobile phone are connected in the prior art.
FIG 2 is a structural diagram showing a housing and a screen according to an example useful for understanding the present invention, but not falling under the scope of protection.
FIG 3 shows a structure connecting a display module to a protective frame according to a specific example useful for understanding the present invention;
FIG 4 is a structural diagram of a component including a screen and a housing whose side face undergoes glue dispensing before the housing and the screen are pressed together according to an example useful for understanding the present invention, but not falling under the scope of protection;
FIG 5 is a component including a screen and a housing that includes a first joint face and a second joint face according to a specific embodiment of the present invention; and
FIG 6 is a structural diagram of a component including a screen and a housing whose bottom's side face undergoes glue dispensing before the housing and the screen are pressed together.

### DESCRIPTION OF EMBODIMENTS

To make the purpose, technical solutions, and advantages of the embodiments of the present invention clearer, the following describes the technical solutions of the embodiments of the present invention with reference to the accompanying drawings in the embodiments of the present invention.

The embodiments of the present invention provide a component including a housing and a screen. Glue is disposed on an inner side face of the housing, so that the inner side face of the housing is directly connected to an outer side face of the screen. In this way, a problem that a frame is increased in size caused when a step is used as an auxiliary joint face to be connected to the screen, is avoided, thereby reducing a width of the frame of a mobile phone.

In a specific embodiment of the present invention, a display module used in the screen may be a liquid crystal display (Liquid crystal display, LCD), may be an active matrix/organic light emitting diode panel (AMOLED, Active Matrix/Organic Light Emitting Diode), or may be any other display device for display.

FIG 2 is a structural diagram showing a housing and a screen according to an example useful for understanding the present invention. As shown in FIG. 2, a housing 201 and a screen 202 are included. The screen 202 is a combined module including cover glass (CG, Cover Glass) 204, a display module 203, and a touch panel (Touch Panel). The display module 203 may be an LCD, may be an AMOLED, or may be any other display device for display. For ease of description, the display module is used in all specific embodiments of this application for description.

In an example, the touch panel is embedded in the display module 203 to reduce thickness of the screen 202. The cover glass 204 is disposed on the display module 203 to prevent the display module 203 from being damaged, scratched, or the like in daily use.

In an example, the cover glass is disposed on the display module, and an area of the cover glass 204 is greater than an area of the display module 203.

Alternatively, in an example, the touch panel and the display module 203 may be separately disposed. For example, the touch panel is disposed on the display module 203, and the cover glass 204 is disposed on the touch panel, to prevent the touch panel from being damaged, scratched, or the like in daily use.

In an example, the screen 202 further includes a protective frame 205, and the protective frame 205 is configured to wrap the display module 203. The protective frame 205 is configured to protect the display module 203 in the screen 202, so that the display module 203 bears more uniform pressure, relatively small pressure, or even no pressure after being connected to the housing 201.

In an example, wrapping the display module 203 may be totally wrapping the bottom and a side face of the display module 203, or may be totally wrapping the bottom of the display module 203, or may be wrapping a backlight plate on a side face of the display module 203. In this case, the backlight plate is not in contact with glue when the screen 202 is connected to the housing 201; and the backlight plate of the display module 203 bears more uniform pressure, relatively small pressure, or even no pressure after the display module 203 is connected to the housing.

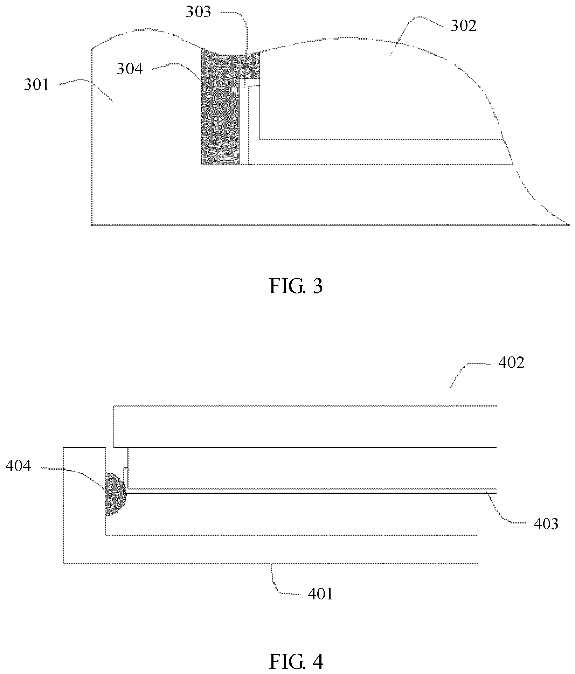

In an example, FIG. 3 shows a structure connecting a display module to a protective frame. As shown in FIG 3, a housing 301 and a display module 302 are included. In an example, the housing may be any one of a front housing, a middle frame, a rear housing, and the like. A protective frame 303 is further disposed on the screen 302, and the protective frame 303 is of a frame structure. A backlight plate of the display module 302 is protected by using the protective frame 303. Specifically, the protective frame 303 is disposed on a side face of the display module 302 and is fastened onto the display module 302. The bottom of the protective frame 303 is connected to the bottom of the housing, so as to avoid impact on a normal operation of the backlight plate at the bottom of the screen 302 by preventing glue 304 from flowing into the backlight plate.
In a specific embodiment of the present invention, the protective frame may be in multiple forms, and a specific structure of the protective frame is not limited in the present invention. Any component that includes the housing and that is formed by wrapping or isolating the backlight plate of the display module by using a structure to make a luminous part to bear relatively small pressure or even no pressure and then by connecting the screen including the protective frame to the housing falls within the protection scope of the present invention, which is defined by the appended claims.

In a specific embodiment of the present invention, the screen is disposed in a groove of a cross section of the housing, and the housing is connected to the screen by using the glue.

In a specific example, FIG 4 is a structural diagram of a component including a screen and a housing whose side face undergoes glue dispensing before the housing and the screen are pressed together. As shown in FIG 4, glue 404 is disposed on an inner side face of the housing 401. The screen 402 includes a protective frame 403. The mobile phone component that includes the housing and that is formed after the screen 202 and the housing 201 are pressed together is shown in FIG 2. After the screen 202 and the housing 201 are pressed together, a side face of the housing 201 is connected to side faces of the protective frame 205 and the display module 203 by using glue 206, so as to form a first joint face between the housing and the display module provided with the protective frame. In this case, the housing 201 is connected to the screen 202 by using the first joint face.

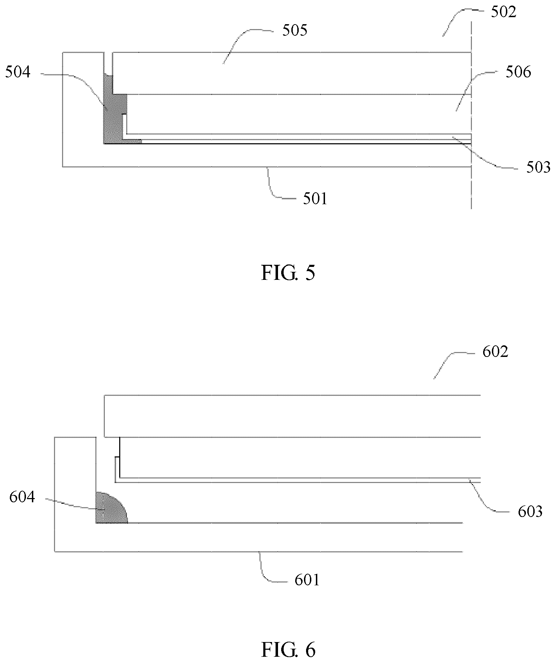

FIG 5 is a component including a screen and a housing that includes a first joint face and a second joint face according to a specific embodiment of the present invention. As shown in FIG 5, in the example shown in FIG 4, a housing 501 is connected to a screen 502 by using glue 504. A quantity of joint faces between the display module 502 and the housing 501 may further be increased by adjusting an amount of glue 504 that is disposed on an inner side face of the housing 501 during glue dispensing. The inner side face of the housing 501 is connected to side faces of the protective frame 503 and the display screen 506 by using the glue 504, and the circumference of the bottom of the housing 501 is connected to the circumference of the protective frame 503 by using the glue 504. A first joint face is formed between the housing and the display module provided with the protective frame, and a second joint face is formed between the inner side face of the housing 501 and cover glass 505. The housing 501 is connected to the screen 502 by using the first joint face and the second joint face. The second joint face may further make the screen water-proof and dust-proof, improving performance of the component including the housing.

FIG 6 is a structural diagram of a component including a screen and a housing whose bottom's side face undergoes glue dispensing before the housing and the screen are pressed together. As shown in FIG 6, a housing 601 and a screen 602 are included, the screen 602 includes a protective frame 603, and the glue 604 is dispensed at the bottom of a side face of the housing 601. According to an amount of the glue that is dispensed, a structural diagram, show in FIG 2, of a mobile phone housing whose side face undergoes glue dispensing may be formed, or the component, shown in FIG 5, including the screen and the housing that includes the first joint face and the second joint face according to the specific embodiment of the present invention may be formed.

## Claims

1. A component comprising a housing (501, 601) and a screen (502, 602), wherein the screen (502, 602) comprises cover glass (505) at a top of the screen (502, 602), a touch panel, and a display module (506) at a bottom of the screen (502, 602), and the display module (506), the touch panel, and the cover glass (505) are connected in sequence from the bottom to the top; the screen (502, 602) further comprises a protective frame (503, 603), and the protective frame (503, 603) wraps the bottom of the display module (506) at the bottom of the screen (502, 602) and a side face of the display module (506); and glue (504, 604) is disposed on a side face of the screen (502, 602) at the wrapped side face of the display module (506), wherein a first joint face is formed between the housing (501, 601) and the display module (506) provided with the protective frame (503, 603), a second joint face is formed between the housing (501, 601) and the cover glass (505), and the housing (501, 601) is connected to the screen (502, 602) by using the glue (504, 604) at the first joint face and the second joint face.

2. The component according to claim 1, wherein the protective frame (503, 603) totally wraps the bottom and the side face of the display module (506).

## Patentansprüche

1. Komponente mit einem Gehäuse (501, 601) und einem Bildschirm (502, 602), wobei der Bildschirm (502, 602) ein Abdeckglas (505) an der Oberseite des Bildschirms (502, 602), ein Berührungsfeld und ein Anzeigemodul (506) an der Unterseite des Bildschirms (502, 602) umfasst, und das Anzeigemodul (506), das Berührungsfeld und das Abdeckglas (505) nacheinander von unten nach oben verbunden sind; der Bildschirm (502, 602) ferner einen Schutzrahmen (503, 603) umfasst und der Schutzrahmen (503, 603) die Unterseite des Anzeigemoduls (506) an der Unterseite des Bildschirms (502, 602) und eine Seitenfläche des Anzeigemoduls (506) umschließt; und Klebstoff (504, 604) auf einer Seitenfläche des Bildschirms (502, 602) an der umschlossenen Seitenfläche des Anzeigemoduls (506) angeordnet ist, wobei eine erste Verbindungsfläche zwischen dem Gehäuse (501, 601) und dem Anzeigemodul (506), das mit dem Schutzrahmen (503, 603) versehen ist, gebildet ist, eine zweite Verbindungsfläche zwischen dem Gehäuse (501, 601) und dem Abdeckglas (505) gebildet ist und das Gehäuse (501, 601) mit dem Bildschirm (502, 602) unter Verwendung des Klebstoffs (504, 604) an der ersten Verbindungsfläche und der zweiten Verbindungsfläche verbunden ist.

2. Komponente nach Anspruch 1, wobei der Schutzrahmen (503, 603) die Unterseite und die Seitenfläche des Anzeigemoduls (506) vollständig umschließt.

## Revendications

1. Composant comprenant un boîtier (501, 601) et un écran (502, 602), dans lequel l'écran (502, 602) comprend un verre de protection (505) en haut de l'écran (502, 602), un panneau tactile, et un module d'affichage (506) au bas de l'écran (502, 602), et le module d'affichage (506), le panneau tactile et le verre de protection (505) sont reliés en séquence de bas en haut ; l'écran (502, 602) comprend en outre un cadre de protection (503, 603), et le cadre de protection (503, 603) enveloppe le bas du module d'affichage (506) au bas de l'écran (502, 602) et une face latérale du module d'affichage (506) ; et de la colle (504, 604) est disposée sur une face latérale de l'écran (502, 602) au niveau de la face latérale enveloppée du module d'affichage (506), dans lequel une première face de joint est formée entre le boîtier (501, 601) et le module d'affichage (506) pourvu du cadre de protection (503, 603), une seconde face de joint est formée entre le boîtier (501, 601) et le verre de protection (505), et le boîtier (501, 601) est relié à l'écran (502, 602) en utilisant la colle (504, 604) au niveau de la première face de joint et de la seconde face de joint.

2. Composant selon la revendication 1, dans lequel le cadre de protection (503, 603) enveloppe totalement le fond et la face latérale du module d'affichage (506).
